(19) Europäisches Patentamt

European Patent Office

Office européen des brevets

(11) **EP 1 696 612 A1**

(12) **EUROPEAN PATENT APPLICATION**

(43) Date of publication:
30.08.2006 Bulletin 2006/35

(51) Int Cl.:
*H04L 12/56* (2006.01)

(21) Application number: 05300144.2

(22) Date of filing: 24.02.2005

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(71) Applicant: **Sun Microsystems France S.A.**
**78142 Vélizy cedex (FR)**

(72) Inventors:
• **Vigouroux, Xavier-François**
**Sun Microsystems France**
**78142, Velizy Cedex (FR)**

• **Tourancheau, Bernard**
**01700 Miribel (FR)**
• **Koch-Hofer, Cédric**
**38400 Saint Martin d'Heres (FR)**

(74) Representative: **Weihs, Bruno Konrad et al**
**Osha Liang**
**121, Avenue des Champs Elysées**
**75008 Paris (FR)**

(54) **Optimal communication path routing in a system employing interconnected integrated circuit technology**

(57) An electronic system is described in which integrated circuits employing cornered I/O are arranged in a framework including an optional path manager and at least one updateable routing table. Packet routing options are described with solutions being provided to minimize transmission latency and pathway alternatives.

FIG. 3

EP 1 696 612 A1

**Description**

**Cross-reference to related applications**

This application is a continuation-in-part of U.S. Patent Application No. 10/853,936, filed May 26, 2004 and entitled "SYSTEM AND METHOD FOR DETERMINING A CARRIER LAYOUT USING CORNERED CHIP-TO-CHIP INPUT/OUTPUT."

**Statement Regarding Federally Sponsored Research or Development**

This invention was made with United States Government support under contract NBCH020055 awarded by the Defense Advanced Research Projects Administration. The United States Government has certain rights in the invention.

**Background**

In electronic systems employing devices that must communicate with each other in order to accomplish tasks, it is important to ensure that packets are received at the intended destination device in a timely fashion. In systems employing interconnected integrated circuits, there may be multiple communications pathways that may be coupled together within the system as well as to the external environment. Thus, multiple possible communications pathways exist between the source and destination devices. Choosing one path over another for communications at a given moment may be inconsequential in systems where communication speed and efficiency is not a paramount concern. However, in systems having many such pathways and where communication speed needs to be optimized, communications pathway choice needs to be carefully considered.

In systems having just a few choices of possible communications pathways, it may be relatively simple to choose the communications pathway to use that minimizes the time a packet is in transition between the source and destination devices. However, in larger systems employing many devices and having many possible communications pathways between devices, it is necessary to approach the choice of a pathway more carefully. Further, having a systematic method for choosing an optimum pathway that minimizes transit time between source and destination increases system efficiency.

In a system having multiple intersecting communications pathways, a signal being routed from a source device to a destination device may have several possible choices of pathways at each intersection. For example, in a rectangular layout where a signal is going from the lower right corner to the upper left cornmer, there are likely to be many possible choices for routing a signal at each intersection. In addition to considering latency when routing a signal, other factors are considered, such as the possibility that a portion of a pathway may fail, thus requiring the system to reroute the signal.

**Summary**

According to one aspect of one or more embodiments of the present invention, in an electronic system having multiple capacitively coupled interconnected rectangular integrated circuits forming multiple pathways for routing data packets between a source integrated circuit and a destination integrated circuit, a method is presented for routing a data packet. That method includes determining the minimum number of buses the packet needs to travel over in each of at least two directions order to reach the destination integrated circuit, and causing the packet to be sent using an available pathway in the direction having the higher of those two numbers in that direction.

According to one aspect of one or more embodiments of the present invention, an electronic system is described employing one or more integrated circuits having multiple communication pathways therein, those integrated circuits being interconnected to form a communications framework having at least one instance of multiple pathways being present between a source chip having a packet to send and a destination chip which is the destination for the packet.

According to another aspect of one or more embodiments of the present invention, routing is determined through the use of a path manager and updateable routing tables coupled to the integrated circuits, the routing table being updated by the path manager when the availability of a pathway changes.

According to another aspect of one or more embodiments of the present invention, the choice of pathways to use when routing the packet is at least partially dependent on the relative latency of available pathways, the choice being made to route the packet over the pathway which minimizes latency.

According to another aspect of one or more embodiments of the present invention, the choice of pathways to use when routing the packet is at least partially dependent on the number of available alternative pathways, the choice being made to route the packet over the pathway which minimizes latency and also maximizes the number of alternative pathway choices at devices likely to be handling the packet.

According to another aspect of one or more embodiments of the present invention, an electronic system employing the invention optionally includes a plurality of integrated circuits employing cornered I/O technology, which may be capacitively coupled along an overlapping edge with at least one other integrated circuit.

Buses within the system may be oriented approximately horizontally and vertically and the directions approximate left, right, up, and down. Buses may alternatively be oriented approximately diagonally, and the directions approximate upper left, upper right, down left, and down right.

According to another aspect of one or more embodiments of the present invention, a method for routing a packet in an electronic system includes determining a minimum number of horizontal and vertical buses the packet needs to travel in order to reach a destination chip and causing the packet to be sent using an available pathway in the direction having the greater of the two numbers.

The method further includes updating, once the packet has traveled using at least one bus in a given direction, the number of buses left to be taken in that given direction, determining if a pathway is available by consulting a routing table listing available pathways, and determining the best available pathway to be a pathway among the available pathways that minimizes latency.

In one or more embodiments of the present invention, an electronic system employing one or more embodiments of the present invention further includes at least one routing table, and the method further includes determining if a pathway is available by consulting the at least one routing table listing available pathways, and determining the best available pathway to be a pathway among the available pathways that minimizes latency and maximizes alternative pathway choices of devices that are anticipated to handle the packet at a later time.

In one or more embodiments of the present invention, an electronic system includes a plurality of interconnected devices employing cornered I/O, at least two of the devices each having at least two communications pathways disposed therein, at least one updateable routing table, and a routing table manager device configured to receive information regarding an availability of pathways in adjacent devices and update the routing table when the availability of a pathway changes.

The system alternatively further includes an indication of a relative transmission latency of at least one pathway as compared to another pathway, wherein one indicator of relative latency is an ordering of the pathways in the routing table.

The routing table manager device of the system may be configured to determine whether portions of the communications pathways are unavailable for communication by receiving information regarding the availability of a pathway from another device in the system.

The routing table manager device may also be further configured to determine whether portions of the communications pathways are available for communication by transmitting a packet using the communications pathway and receiving an indication of packet receipt from the destination chip. Such transmission of a packet may be triggered to take place during initialization of the system.

The routing table manager device may instead be configured to determine that a pathway is not available through failure of an acknowledgement of receipt to arrive.

Other aspects of the invention will be apparent from the following description and the appended claims.

**Brief Description of Drawings**

FIGS. 1A and 1B are functional block diagrams of integrated circuit (IC) carriers employing cornered input/output (I/O).

FIG. 2 is a functional block diagram showing capacitive coupling between chips according to one or more embodiments of the present invention.

FIG. 3 is a functional block diagram of a system of interconnected integrated circuits in accordance with an embodiment of the present invention.

FIG. 4 is a functional block diagram of a system of interconnected integrated circuits showing possible communications pathway choices in accordance with an embodiment of the present invention.

FIG. 5 is a flowchart of a technique for routing a packet from a source chip to a destination chip in accordance with an embodiment of the present invention.

FIG. 6 is a flowchart of a technique for managing information relating to available pathways in accordance with an embodiment of the present invention.

**Detailed Description**

In this description, reference is made to integrated circuits and chips. Integrated circuits are typically referred to as circuitry present on a substrate, while chips are often meant to include additional structure such as packaging, switching functionality, interconnects, etc. It is intended that both terms be construed broadly and synonymously, so that each refers generally to circuits containing functionality, some of that circuitry being deposited on a substrate.

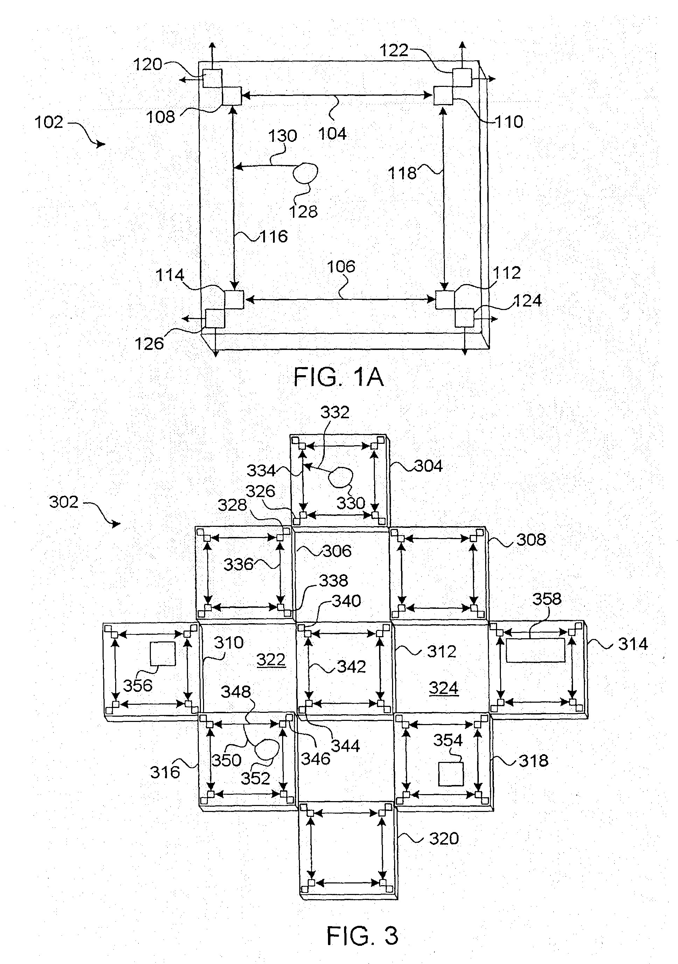

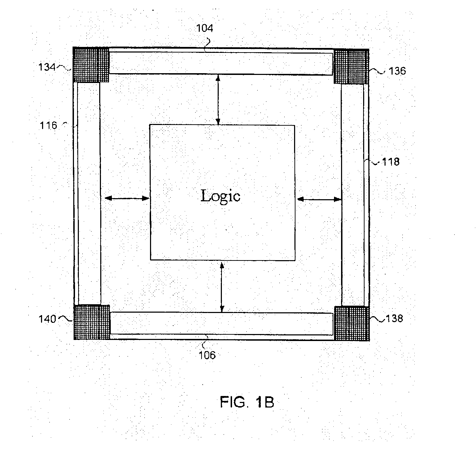

FIGS. 1A and 1B are functional block diagrams of integrated circuit (IC) carriers employing cornered input/output (I/O). When using cornered I/O, the I/O interfaces to the external environment are positioned generally towards the corners of a rectangular carrier containing the IC. A similar carrier employing cornered I/O is described in U.S. Patent Application No. 10/853,936 referenced above.

Data is transferred from one point to another over, for example, buses and pathways. "Pathways" refer to any form of communication medium through and between integrated circuits or chips over which data may pass from source to destination. By way of example, such a communication medium may include wireless transmission (e.g. capacitive coupling and the like) I/O pads that are physically connected to other circuitry, or any other suitable interface.

Those of ordinary skill in the art having the benefit of this disclosure will readily recognize that such integrated circuits may be similar and therefore have similar transmission latencies throughout. However, it is also true that the integrated circuits may differ in their configurations and therefore have dissimilar latencies. Latencies of communications pathways within integrated circuits may be determined by calculation, experimentally sending packets, or other techniques known to those of ordinary skill in the art.

In one or more embodiments of the present invention, latencies of pathways are determined experimentally during or within a reasonably short period following a power-up cycle. At such a time, packets are originated by each integrated circuit in the system, to each destination, and the time it takes for each packet to reach its destination is measured for various routing scenarios. Such information is then used to prepare routing tables which govern how packets travel from source to destination.

Referring to FIG. 1A, chip **102** has horizontal data buses **104** and **106.** Bus **104** is configured to pass packets within chip **102** between circuits **108** and **110.** Bus **106** is configured to pass packets within chip **102** between circuits **112** and **114.** Chip **102** also has vertical data buses **116** and **118.** Bus **116** is configured to pass packets within chip **102** between circuits **108** and **114.** Bus **118** is configured to pass packets within chip **102** between circuits **110** and **112.** I/O circuits **120, 122, 124,** and **126** are configured to pass packets between their respective adjacent circuits **108, 110, 112,** and **114** and the external environment. Although the data buses shown in FIG. 1 are generally oriented horizontally and vertically, the location of circuits **108, 110, 112,** and **114** may be located in a different arrangement, such as approximately midway between the corners of each chip, accordingly causing buses **104, 106, 116,** and **118** to be arranged differently. The exemplary chip configurations depicted and described herein are not intended to be limiting.

Buses **104, 106, 116** and **118** may be implemented in a variety of ways. For example, in one or more embodiments of the present invention, a bus may be bidirectional. In one or more other embodiments of the present invention, a bus may comprise a single pathway providing one way communication. In one or more other embodiments of the present invention, a bus may comprise a combination of one way pathways providing the equivalent of a bidirectional bus. In one or more embodiments of the present invention, multiple unidirectional or bidirectional buses may be present adjacent to each other to pass data between I/O circuits within a chip.

Referring to FIG. 1B, in an exemplary embodiment employing cornered I/O, where capacitive coupling between integrated circuits instead of more traditional pin-based connectivity, I/O pads 134, 136, 138, and 140 provide capacitive coupling between I/O circuits present on adjacent integrated circuits. Although depicted as a hatched surface, these I/O pads provide connectivity to many signal pathways each, thus providing multiple signal pathways per pad. Additional information regarding this form of connectivity is described in "Proximity Communication" by Robert J. Drost, Robert David Hopkins, and Ivan E. Sutherland (2003).

In one or more embodiments of the present invention, I/O pads such as 134, 136, 138, and 140 employ traditional pin-based connectivity. Persons of ordinary skill in the art having the benefit of this disclosure will readily discern other connectivity methods that may be employed while remaining within the scope and spirit of the present invention.

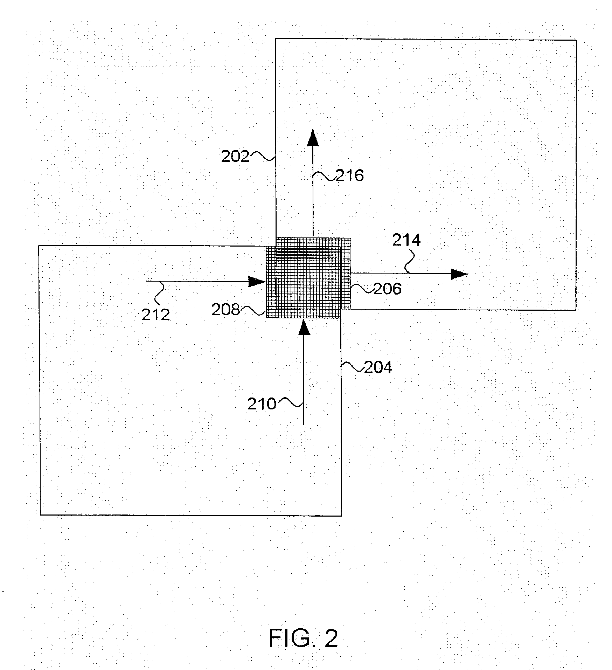

FIG. 2 is a functional block diagram showing capacitive coupling between integrated circuits according to one or more embodiments of the present invention.

Referring to FIG. 2, chips 202 and 204 each have respective I/O pads 206 and 208 which capacitively couple signals between buses 210, 212, 214, and 216. Thus, a signal on bus 210 which is bound for chip 202 either as a final destination or as an intermediate destination headed for a different chip in the system will be transmitted through I/O pad 208 to I/O pad 206, and then to either of bus 214 or bus 216 as appropriate, depending on the final destination for the signal.

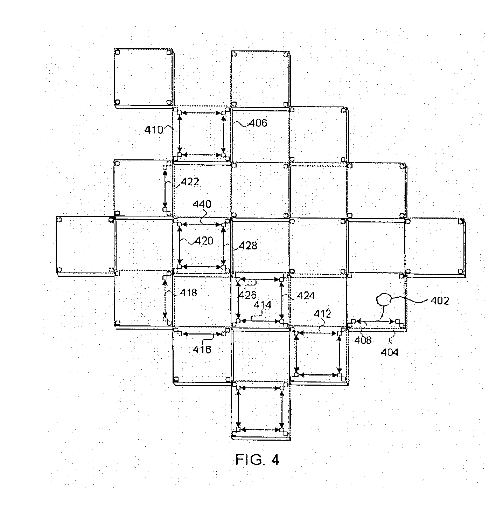

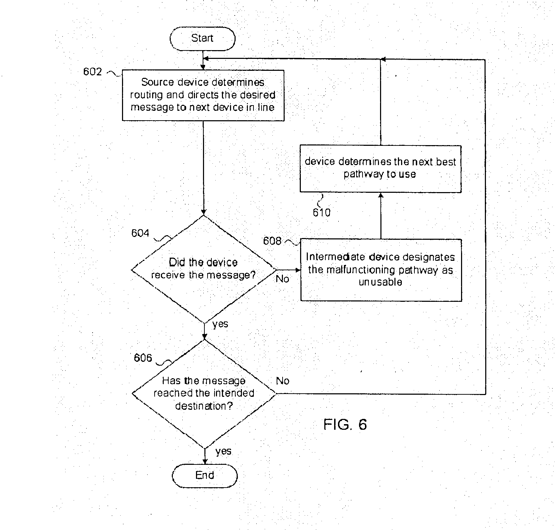

FIG. 3 shows an exemplary functional block diagram of a system of interconnected integrated circuits in accordance with an embodiment of the present invention. In FIG. 3, system 302 includes integrated circuits 304, 306, 308, 310, 312, 314, 316, 318 and 320 interconnected in a grid framework. Although this framework has an overall diamond shape, persons of ordinary skill having the benefit of this disclosure will readily recognize that, in one or more other embodiments of the present invention, other framework shapes and configurations are possible (e.g., rectangular, diamond). Further, although the exemplary configuration shown in FIG. 3 has spaces 322 and 324 within the framework, in one or more other embodiments of the present invention, configurations are possible that do not have spaces, such as those depicted in FIGS. 6A, 6B, and 6C of the '936 application. The exemplary framework configurations depicted and described herein are not intended to be limiting.

Adjacent integrated circuits, such as integrated circuits 304 and 306, are coupled at their respective corners so that the respective I/O circuitry, such as I/O circuitry 326 and 328, are in communication with each other. Thus, in one embodiment of the present invention, a packet originating within chip 304 destined for chip 316 may pass from an area 330 within chip 304 over pathway 332 to bus 334, through I/O circuitry 326 and 328, over bus 336 through I/O circuitry 338, over bus 340, through I/O circuitry 338 and 340, to bus 342, through I/O circuitry 344 and 346 to bus 348 at which time the packet may leave bus 348 over pathway 350 to arrive at area 352 within chip 316. Those of ordinary skill in the art having the benefit of this disclosure will readily recognize that several other communications paths (e.g., combinations of buses, I/O circuitry, etc. from one or more integrated circuits) exist that may alternatively be used to transmit a packet from chip 304 to chip 316.

In one or more embodiments of the present invention, at least one chip in the system includes updateable memory space, such as memory space 354 within chip 318, for storing information such as routing tables therein. In one embodiment of the present invention, shareable memory space, such as shareable memory space 356, within which routing tables and other information may be stored, may be shared by one or more integrated circuits, such as integrated circuits 310 and 316.

In one or more embodiments of the present invention, where shared memory space, such as memory space 356, is employed, an adjacent chip, such as chip 316, may determine proper routing for a packet by accessing routing information stored within shared memory 356.

In one or more embodiments of the present invention, at least one chip, such as chip 314, includes a routing table manager 358. In one embodiment of the present invention, routing table manager 358 is notified when one or more buses, such as bus 342, has been determined to be unusable. In this embodiment, should such a failure occur, routing table manager 358 communicates the failure to integrated circuits in the system having memory spaces containing routing tables, such as integrated circuits 308, 310, and 318, to ensure that the respective routing tables are updated to route packets around the failed bus or buses.

In one or more embodiments of the present invention, a packet is routed by accessed routing information from within a memory space, such as memory space 354 within chip 318. It is important to route a packet over the pathway that minimizes transmission latency. Those of ordinary skill having the benefit of this disclosure will readily recognize that transmission latency may often be minimized, for a given packet, by determining the communications path having the fewest chip-to-chip transfers of that packet between source and destination.

FIG. 4 shows an exemplary functional block diagram of a system of interconnected integrated circuits showing possible communications pathway choices in accordance with one or more embodiments of the present invention. In FIG. 4, by way of example, a packet originating from area **402** of chip **404** destined for chip **406** may be routed over one of several possible pathways. One such pathway includes routing a packet from area **402** over conduit **406** to bus **408,** thereafter routed to bus **410** over buses **412, 414, 416, 418, 420,** and **422,** at which time the packet arrives at destination chip **406.**

Each time a packet passes over a bus within a chip, there is a bus latency cost **b.** When a packet passes from one chip to another, there is a further chip interconnect cost $c_i$. Thus, with respect to the exemplary path routing of the packet from area **402** of chip **404** to chip **406** described above, assuming the chip bus latencies and the chip interconnect costs are relatively equal when comparing one integrated circuit to another, using this path routing results in a total cost of approximately 8**b** + 7**$c_i$**.

Alternatively, a packet originating from the same area **402** of chip **404** destined for chip **406** may be routed from area **402** over conduit **406** to bus **408,** thereafter routed to bus **410** over buses **412, 424, 426** and **428** and **430,** at which time the packet arrives at destination chip **406.**

For this exemplary path routing, again assuming the chip bus latencies and the chip interconnect costs are relatively equal when comparing one integrated circuit to another, the total cost is approximately 9**b** + 5**$c_i$**. Thus, this path routing has less transmission latency than the path routing described above having a total cost of approximately 9**b** + 7**$c_i$** due to the difference between the path routings in the amounts of chip-to-chip relays of the packet.

By way of example, assume the grid is rectangular, and arranged as a coordinate grid, where the source integrated circuit is at coordinate (0,0) and the destination is at coordinate (x,y), where x>=y. It can be shown in a system having relatively equal bus latencies and chip interconnect costs through the grid of interconnected integrated circuits, that the total cost c of the shortest paths available between two integrated circuits is computed as follows

$$c = ((x-1) + (y-1))*b + x*c_i$$

The number **n** of such shortest paths may be computed as

$$n = \frac{I!(2^{y-1})}{((y-1)!(I-(y-1))!}$$

where

$$I = \frac{((y-1)+(x-1))}{2}$$

In FIG. 4, many pathways exist that may be used for the transmission of a signal from a given source chip to a given destination chip. Several methods of routing may employ present invention techniques, including, but not limited to, source routing, intermediate routing, and "on-the-fly" routing.

Source routing is a routing technique where the destination of the packet is known and the source integrated circuit fully determines the routing of the packet before sending it to the destination. When using source routing, the latency of complete pathways available between source and destination may be considered when routing the packet.

Intermediate routing is where the source chip "knows" the destination and indicates, as described in the '936 Application, the number of horizontal and vertical hops a packet must take to get to the destination chip. Using this type of routing, the intermediate integrated circuits forwarding the packet decrement the given count of horizontal or vertical hops the packet has to take in order to reach the intended destination. When using intermediate routing, a system may cause one or more intermediate integrated circuits to review its routing table information to determine at least a portion of the best pathway to follow to another intermediate chip or to the destination chip.

"On-the-fly" routing is where the source specifies the destination chip in the packet header (or other convenient portion of the outgoing packet) and each intermediate chip determines the best pathway to use to forward the packet to the next intermediate chip towards the destination chip. When using "on-the-fly" routing, the source chip and each intermediate chip handling a given packet "decides," based on routing and latency information, where to next send the packet to get the packet to the final destination chip as quickly as possible.

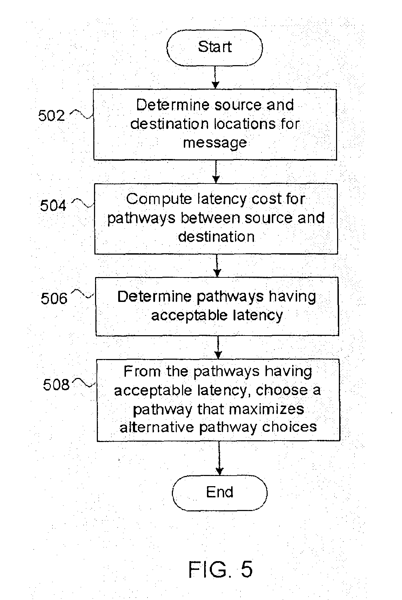

FIG. 5 shows an exemplary flowchart of a technique for routing a packet from a source chip to a destination chip in accordance with an embodiment of the present invention.

In FIG. 5, the technique begins at step **502** when the source and destination integrated circuits for the packet are determined.

In step **504,** a prediction is made of latency for pathways between the source and destination devices. In one or more embodiments of the present invention, such a prediction may be made from actual transmission latency resulting from previous similar packets that have been sent from the same source to the same destination. In one or more other embodiments of the present invention, a prediction may be based on computations using individual latencies based on the configuration of integrated circuits within the system. In one or more other embodiments of the present invention, a prediction may be based on a combination of actual transmission latency information and computational information.

In step **506,** a determination of pathways having acceptable latency is made. In one or more embodiments of the present invention, such a determination may include a ranking of available pathways and choosing the best one or more pathways from the higher ranked pathways. In one or more other embodiments of the present invention, acceptable pathways may be determined by choosing an acceptable latency based on a distance the packet will have to travel.

In optional step **508,** primarily used in intermediate and "on-the-fly" routing, a pathway is chosen that maximizes the number of alternative choices for pathway routing at each chip receiving the packet for retransmission. By way of example, when using intermediate routing where the number of horizontal and vertical hops is specified, if two choices of pathways at a given moment are seen to be equal in terms of transmission latency, it is often best to send the packet along the pathway which maximizes the number of possible pathway choices for intermediate destinations down the path. Should a potential pathway fail for some reason while the packet is in route, the number of pathway choices will diminish due to the failed pathway; however there will still likely be more choices available than in a case where the number of alternative pathways was not maximized in a retransmitting chip.

In one or more embodiments of the present invention, the number of alternative pathways may be maximized by causing, whenever possible, the packet to travel down the direction (e.g., horizontal or vertical for rectangular frameworks) having the most needed hops. Thus, if a destination is three vertical hops away, but seven horizontal hops away, the requirement to maximize alternatives would result in the packet being sent multiple horizontal hops for each vertical hop taken until the number of horizontal and vertical hops is approximately equal. The number of pathways available at any given time may be computed using the formula previously described.

In a large system having many different pathway choices for sending a particular packet, it is important to know if a pathway or a portion of a pathway has failed or is otherwise unavailable so that packet are routed around the unavailable pathway.

FIG. 6 shows an exemplary flowchart showing a technique for managing information relating to the available pathways in accordance with an embodiment of the present invention. In FIG. 6, the technique begins at step **602** where a device having a packet to send determines the routing for the packet and sends the packet to the next device in line to receive the packet.

In step **604,** it is determined whether the packet was received properly. If the packet was received properly, the technique proceeds to step **606** where it is determined whether the packet has reached its final destination.

If the packet has reached its final destination, the technique ends. Otherwise, if the packet has not reached its final destination, the technique proceeds back to step **602.**

If, in step **604,** the receiving device did not receive the packet, the technique proceeds to step **608** when the sending device designates the malfunctioning pathway as unusable. The designation of the unusable pathway may occur in any one or more of many possible ways, all of which are within the spirit of the present invention. In one or more embodiments of the present invention, the pathway manager determines which portions of which pathways are unavailable, leaving all other functioning portions of pathways free to pass data. By way of example, in those systems having a pathway manager, the device sends a packet to the pathway manager regarding the unusable pathway. In this case, the pathway manager updates affected routing tables to ensure that the unavailable pathway is not used. If the system has no path manager, the device may update its own routing table and send a packet to other affected devices causing them to also update their routing tables. In this case, affected devices include, but are not limited to, any device that is immediately adjacent and directly connected to the device having the unavailable pathway, and also devices that may have otherwise used the unavailable pathway to send a packet.

In one or more embodiments of the present invention, I/O interfaces are present along the edges of chips interconnected using overlapping capacitive coupling. Thus, rather than chips interfacing at the corners, one or more chips interface along an edge, using capacitive coupling to facilitate information transfer between the chips.

In one or more embodiments of the present invention, alternative pathway choices over pathways having similar latencies. This maximizes the possibility of local pathway congestion delaying the forwarding of a packet on to its destination.

In one or more embodiments of the present invention, packets in the system being forwarded between the source and destination are able to be routed around failed pathways, thus minimizing packet losses due to failing pathways within integrated circuits.

While the invention has been described with respect to a limited number of embodiments, those skilled in the art, having benefit of this disclosure, will appreciate that other embodiments can be devised which do not depart from the scope of the invention as disclosed herein. Accordingly, the scope of the invention should be limited only by the attached claims.

### Claims

1. A method of routing a data packet in an electronic system comprising:

   determining a minimum number of buses (104) the packet needs to traverse in each of at least two directions in order to reach a destination integrated circuit; and
   causing the packet to be sent using an available pathway (332) in the direction having the higher number.

2. The method of claim 1, wherein said system includes a plurality of said integrated circuits (202) employing cornered I/O technology.

3. The method of claim 1 further comprising:

   determining if a pathway (332) is available by consulting a routing table listing available pathways; and
   determining the best available pathway to be a pathway (332) among the available pathways that minimizes latency.

4. The method of claim 1, further comprising at least one routing table, and wherein the method further comprises:

   determining if a pathway is available by consulting the at least one routing table listing available pathways (332); and

determining the best available pathway (332) to be a pathway among the available pathways that minimizes latency and maximizes alternative pathway choices of devices that are anticipated to handle the packet at a later time.

5. An electronic system, comprising:

a plurality of interconnected devices (102) employing cornered I/O, at least two of said devices (102) each having at least two communications pathways (332) disposed therein;
at least one updateable routing table, and
a routing table manager device (358) configured to receive information regarding an availability of pathways (332) in adjacent devices and update said routing table when the availability of a pathway (332) changes.

6. The system of claim 5, wherein said information comprises an indication of a relative transmission latency of at least one pathway as compared to another pathway.

7. The system of claim 5, wherein said routing table manager device (358) is configured to determine whether portions of said communications pathways (332) are unavailable for communication by receiving information regarding the availability of a pathway (332) from another device in the system.

8. The system of claim 5, wherein said at least one routing table is further defined as a number of routing tables equal to the number of interconnected devices in said plurality of interconnected devices, and wherein individual ones of said routing tables in embedded within individual ones of said interconnected devices.

9. The system of claim 5, wherein at least one of said interconnected devices is configured to determine when a bus (104) is unavailable due to local congestion and to route a packet to an alternate bus (106) having approximately the same latency criteria.

10. The system of claim 5, wherein pathways having latencies that are deemed equivalent within an acceptable tolerance level are indicated as such in said routing table.

FIG. 1A

FIG. 3

FIG. 1B

FIG. 2

FIG. 4

Start

502 — Determine source and destination locations for message

504 — Compute latency cost for pathways between source and destination

506 — Determine pathways having acceptable latency

508 — From the pathways having acceptable latency, choose a pathway that maximizes alternative pathway choices

End

FIG. 5

Start

602 — Source device determines routing and directs the desired message to next device in line

device determines the next best pathway to use

610

604 — Did the device receive the message?

608 — Intermediate device designates the malfunctioning pathway as unusable

No

yes

606 — Has the message reached the intended destination?

No

FIG. 6

yes

End

# EUROPEAN SEARCH REPORT

**Application Number**

EP 05 30 0144

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 343 611 A (CSELT CENTRO STUDI E LABORATORI TELECOMUNICAZIONI S.P.A) 29 November 1989 (1989-11-29) * abstract; figure 1 * * page 2, line 25 - page 4, line 40; claims * | 1,2 | H04L12/56 |
| A | BEHJAT L ET AL: "A novel eigenvector technique for large scale combinatorial problems in VLSI layout" JOURNAL OF COMBINATORIAL OPTIMIZATION KLUWER ACADEMIC PUBLISHERS NETHERLANDS, vol. 6, no. 3, 2002, pages 271-286, XP009049705 ISSN: 1382-6905 * the whole document * | 1,2 | |

**TECHNICAL FIELDS SEARCHED (Int.Cl.7)**

H04L

~~The present search report has been drawn up for all claims~~

| Place of search | Date of completion of the search | Examiner |
|---|---|---|
| Munich | 30 June 2005 | Ceccarini, G |

EP 1 696 612 A1

European Patent
Office

Application Number

EP 05 30 0144

## CLAIMS INCURRING FEES

The present European patent application comprised at the time of filing more than ten claims.

☐ Only part of the claims have been paid within the prescribed time limit. The present European search report has been drawn up for the first ten claims and for those claims for which claims fees have been paid, namely claim(s):

☐ No claims fees have been paid within the prescribed time limit. The present European search report has been drawn up for the first ten claims.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2

European Patent
Office

**LACK OF UNITY OF INVENTION
SHEET B**

Application Number

EP 05 30 0144

The Search Division considers that the present European patent application does not comply with the requirements of unity of invention and relates to several inventions or groups of inventions, namely:

1. claims: 1,2

   Method for selecting the path route taking into account the direction.
   ---

2. claim: 3

   Method for selecting the path route taking into account the minimum latency.
   ---

3. claim: 4

   Method for selecting the path route taking into account the maximum path choices.
   ---

4. claims: 5-10

   Method for updating a routing table of links availability.
   ---

**EP 1 696 612 A1**

## ANNEX TO THE EUROPEAN SEARCH REPORT
## ON EUROPEAN PATENT APPLICATION NO.

EP 05 30 0144

30-06-2005

| Patent document cited in search report | | Publication date | Patent family member(s) | | Publication date |
|---|---|---|---|---|---|
| EP 0343611 | A | 29-11-1989 | IT | 1219759 B | 24-05-1990 |
| | | | CA | 1326284 C | 18-01-1994 |
| | | | DE | 68917522 D1 | 22-09-1994 |
| | | | DE | 68917522 T2 | 05-01-1995 |
| | | | DE | 343611 T1 | 27-02-1992 |
| | | | EP | 0343611 A2 | 29-11-1989 |
| | | | JP | 2025135 A | 26-01-1990 |
| | | | US | 5048011 A | 10-09-1991 |

EPO FORM P0459